# EUROPÄISCHE PATENTSCHRIFT

(11) **EP 1 537 427 B1**
(45) Veröffentlichungstag und Bekanntmachung des Hinweises auf die Patenterteilung: **06.08.2008**
(21) Anmeldenummer: 03753593.7
(22) Anmeldetag: 05.09.2003
(51) Int. Cl.: G01R 31/34, G01R 31/12, G01R 31/06

(54) **VORRICHTUNG UND VERFAHREN ZUR ÜBERWACHUNG UND/ODER ANALYSE VON ELEKTRISCHEN MASCHINEN IM BETRIEB**
DEVICE AND METHOD FOR MONITORING AND/OR ANALYZING ELECTRIC MACHINES IN OPERATION
DISPOSITIF ET PROCEDE POUR SURVEILLER ET/OU ANALYSER DES MACHINES ELECTRIQUES EN COURS DE FONCTIONNEMENT

(30) Priorität: 10.09.2002 CH 15312002
(43) Veröffentlichungstag der Anmeldung: 08.06.2005
(73) Patentinhaber: Alstom Technology Ltd, 5400 Baden (CH)
(72) Erfinder: HOBELSBERGER, Max, CH - 5303 Würenlingen (CH); KIRCHHOFF, Ingo, CH-5454 Bellikon (CH); POSEDEL, Zlatimir, CH-5432 Neuenhof (CH)
(86) Internationale Anmeldenummer: PCT/EP2003/050611
(87) Internationale Veröffentlichungsnummer: WO 2004/025316

(56) Entgegenhaltungen:
- EP-A- 0 271 678
- WO-A-00/69062
- US-A- 3 934 459
- US-A- 4 814 699
- US-A- 5 006 769

## Beschreibung

### TECHNISCHES GEBIET

Die vorliegende Erfindung betrifft eine Vorrichtung und ein Verfahren zur Überwachung und/oder Analyse von elektrischen Maschinen im Betrieb. Die elektrische Maschine umfasst dabei wenigstens einen Generator mit einer Welle sowie Antriebsmittel zum Antrieb dieser Welle, wobei die Welle an der ersten Seite des Generators im wesentlichen unmittelbar geerdet ist und wobei an der Welle an der zweiten Seite des Generators eine Messeinheit zur Messung von Wellenspannung und/oder Wellenstrom als Funktion der Zeit vorgesehen ist. Es handelt sich dabei insbesondere um eine Vorrichtung zur Verwendung bei Kraftwerksanlagen.

### STAND DER TECHNIK

Elektrische Maschinen, insbesondere grosse elektrische Maschinen, wie sie bei Kraftwerksanlagen verwendet werden, sollten, um einen reibungslosen Betrieb zu gewährleisten, kontinuierlich überwacht werden und/oder von Zeit zu Zeit analysiert werden, um Fehlerzustände rechtzeitig zu erkennen und unkontrollierte Ausfälle zu vermeiden.

Zu diesem Zwecke gibt es diverse Verfahren und Vorrichtungen für die Vielzahl von möglichen Fehlerzuständen, welche kurz vorgestellt werden sollen.

So beschreibt z.B. die US 5,006,769 eine Vorrichtung zur Detektion von Windungsschlüssen in der Rotorwicklung von Generatoren. Dabei wird über ein spezielles Erdungsmodul die Wellenspannung gemessen und mittels Fouriertransformation auf spezifische Weise analysiert.

Die EP 0271678 schlägt ihrerseits eine Vorrichtung vor, mit welcher Aussagen über die Funktionstüchtigkeit und Funktionssicherheit der Wellenerdung respektive der Isolation der Welle gemacht werden können. Die dabei vorgeschlagene Vorrichtung, welche eigentlich zur Reduktion von Wellenspannungen vorgesehen ist, lässt Aussagen über die gesamten Erdungsverhältnisse der elektrischen Maschine zu.

Eine ähnliche Vorrichtung offenbart die WO 00/69062, wobei hier ebenfalls ein Wellenspannungs- und Stromüberwachungssystem offenbart wird, welches sich entwickelnde Probleme mit einer rotierenden Maschine über eine Warnmeldung diagnostizieren kann. Dazu wird in diesem System ein Sensor zur Messung des Stroms an der Welle vorgesehen sowie wenigstens ein Sensor zur Messung der Spannung an der Welle sowie ein Detektor zur Bestimmung der Änderungsgeschwindigkeit in diesen beiden Grössen. Weiterhin ist eine Auswertungseinheit vorgesehen, mit welcher eine Warnung als Funktion der Änderung in diesen beiden Grössen ausgegeben werden kann.

In der DE 19742622 wird eine Vorrichtung beschrieben, mit welcher Funkenerosion der Welle (insbesondere bei den Lagern), wie sie beim Vorliegen von hohen Spannungen auftreten kann und meist mit schädlichen Wirkungen verbunden ist, erkannt werden kann, indem Wellenstrom und Wellenspannung der Welle gemessen werden.

Eine Vielzahl von Dokumenten beschreibt Vorrichtungen, welche dazu dienen, Bürstenfeuer an den Schleifringen zu erfassen. Dazugehören z.B. die US 3,653,019, US 4,058,804, US 4,163,227 sowie die US 4,451,786. Dabei wird eine eigens dafür vorzusehende Messvorrichtung direkt an die Bürsten angeschlossen, und, dies ist die Hauptstossrichtung dieser Dokumente, anschliessend eine Datenverarbeitung vorgenommen, welche Störsignale von Nutzsignalen unterscheiden lässt. Dazu wird primär die Gatingmethode verwendet, bei welcher Störsignale erkannt werden und die Detektion während der Störsignale unterbrochen wird (Blanking). Eine andere Methode zur Detektion von Bürstenfeuer wird in der US 4,577,151 vorgeschlagen, bei welcher ein charakteristisches Signal über eine eigens dafür vorzusehende Antenne erfasst wird und anschliessend einer Analyseeinheit zugeführt wird. Die Antenne muss dafür in der Nähe der Schleifringe angeordnet werden, um die entsprechenden hochfrequenten Signale zu empfangen. Die Signale werden anschliessend in einer speziellen Analyseeinheit verstärkt, demoduliert und dann einem Detektor zugeführt.

Ein Verfahren zur Erkennung eines weiteren Fehlerzustandes ist in der US 4,814,699 beschrieben. Es geht darin um die Detektion von Teilentladungen im Stator, Rotor, oder in der Erregervorrichtung. Dabei wird die Welle als Antenne benutzt und die hochfrequenten Pulse über das (isolierte) Wellenlager oder über eine eigens dafür vorzusehende Kopplungsspule ausgekoppelt. Die Lager der

Welle müssen dafür elektrisch bezüglich Erde isoliert sein, und wiederum wird ausgeführt, wie Störsignale in diesem spezifischen Signal von Nutzsignalen unterschieden werden können.

Ein weiterer gravierender Fehlerzustand, welcher ebenfalls überwacht werden muss, besteht in den Schwingungen des Wellenstranges einer Maschine, insbesondere eines Turbogeneratorstranges. Diese Schwingungen können unterschiedlicher Natur sein. Es kann sich dabei um Biegeschwingungen beziehungsweise transversale Vibrationen handeln, welche in senkrechter Richtung zur Welle auftreten. Weiterhin können so genannte Pendelungen auftreten, d. h. in der Regel quasi-periodisch-gedämpfte Änderungen der Dreh-Frequenz der Welle um die Netzfrequenz von üblicherweise 50 Hz (respektive 60 Hz), welche durch z.B. stossartige Störungen im Netz erzeugt werden. Als dritten Typ von Schwingungen der Welle kennt man die eigentlichen Torsionsschwingungen, welche z.B. durch plötzliche Lasterhöhungen am Netz erzeugt werden können. Torsionsschwingungen sind dabei Schwingungen, welche sich in einer uneinheitlichen Rotationsfrequenz entlang der Welle (Phasenverschiebungen respektive Frequenzverschiebungen) manifestieren, d. h. eine Torsion der Welle bewirken.

Bei den Torsionsschwingungen handelt es sich um sehr kleine Schwingungen, üblicherweise im Bereich von 0.01 Grad Phasenamplitude, welche aber dennoch zu einer sehr hohen Belastung der Welle führen können, und insbesondere ein Zusammenfallen der Eigenfrequenz einer derartigen Torsionsschwingung mit dem diese anregenden Stimulus kann zu einem gefährlichen Aufschaukeln von derartigen Torsionsschwingungen führen, was sogar in einem Bruch der Welle resultieren kann. Torsionsschwingungen können dabei Frequenzen von wenigen Hz bis zu 200 Hz haben, wobei die Frequenz natürlich von der Materialbeschaffenheit und Dicke der Welle, der mit der Welle verbundenen Massen und der Grösse der Anlage abhängt. Insbesondere bei grossen Anlagen mit langen Wellen können diese Torsionsschwingungen äusserst kritisch werden.

Der Wichtigkeit dieser Problematik entsprechend haben sich bereits eine Vielzahl von Patentschriften auch mit derartigen Schwingungen beschäftigt. So beschreibt z.B. die US 3,934,459 ein Messgerät respektive ein Verfahren zur Messung der Torsionsschwingungen des gesamten Wellenstranges eines Turbinen-Generator-Systems. Dazu werden über einen oder mehrere nicht näher spezifizierte, eigens dafür vorzusehende Sensoren die Torsionsschwingungen an einem oder mehreren Punkten der Welle aufgenommen. Die Weiterverarbeitung der Torsionssignale ist das Hauptthema dieser Schrift. Die Weiterverarbeitung erfolgt durch Filterung mit Bandfiltern und Multiplikationen, um am Ende die maximalen Torsionsmomente zu ermitteln.

Ausserdem seien in Bezug auf Schwingungen die US 3,885,420, die

US 4,148,222, die US 4,137,780, die US 4,317,371 erwähnt, welche allesamt Messgeräte beziehungsweise Methoden zur Messung von Torsionsschwingungen von derartigen elektrischen Anlagen beschreiben. Zur Erfassung der Torsionsschwingungen werden mit der Welle verbundene, eigens dafür vorzusehende Zahnräder als Signalgeber verwendet, die über Sensoren elektrische Signale erzeugen. Die Signale werden mittels Bandfiltern und Multiplikatoren etc. weiterverarbeitet. In der US 4,317,371 wird eine spezielle Demodulationsmethode zur Messung von Phasenverschiebungen beschrieben. Die Methode umfasst die Erzeugung von niedrigeren Zwischenfrequenzen und die anschliessende Frequenzdemodulation, wie es an sich aus der Rundfunktechnik bekannt ist. Ein anderes Verfahren (US 3,885,420) benützt eine PPL (phase-locked-loop) Schleife zur Demodulation. Ausserdem sei auf die US 4,444,064 hingewiesen, welche eine Methode beschreibt, in der zunächst extra ein magnetisches Muster in die Welle eingeprägt werden muss, das danach als Impulsgeber benützt wird. Ein anderes Konzept der Messung von Torsionsschwingungen beruht darauf, dass die Spannung an den Phasenwicklungsklemmen des Permanentmagnetgenerators, der mit der Welle gekoppelt ist, zur Ermittlung derartiger Schwingungen verwendet wird. Durch Auswertung der erzeugten Spannungen, welche über entsprechende Klemmen abgegriffen werden, wird auf die Torsionsschwingungen geschlossen. Die Auswertung erfolgt wiederum mittels Frequenzdemodulation (PPL-Technik). Als Vorteil dieser Anordnung werden kleinere Kosten im Vergleich mit der Zahnrad-Lösung genannt.

Als weitere gegebenenfalls auftretende Fehlerzustände sei ausserdem z.B. auf mangelhafte Isolation der Rotorwicklung hinzuweisen, sowie auf drehsynchrone Rattermarken und/oder Streifstellen, welche ebenfalls detektiert werden sollten, um Ausfällen vorzubeugen.

### DARSTELLUNG DER ERFINDUNG

Der Erfindung liegt die Aufgabe zugrunde, eine alternative Vorrichtung zur umfassenden Erfassung von Fehlerzuständen einer elektrischen Maschine zur Verfügung zu stellen, welche über eine ausreichende Genauigkeit verfügt und dabei konstruktiv einfach, billig und robust zu realisieren ist, und welche insbesondere kontinuierliche Überwachung beim üblichen Betrieb erlaubt. Dabei handelt es sich um eine Vorrichtung zur Überwachung und/oder Analyse von elektrischen Maschinen im Betrieb, wobei die elektrische Maschine wenigstens einen Generator mit einer Welle sowie Antriebsmittel zum Antrieb dieser Welle umfasst, wobei die Welle an der ersten Seite des Generators im wesentlichen unmittelbar geerdet ist und wobei an der Welle an der zweiten Seite des Generators insbesondere bevorzugt eine Messeinheit zur Messung von Wellenspannung und/oder Wellenstrom als Funktion der Zeit vorgesehen ist.

Die Lösung dieser Aufgabe wird dadurch erreicht, dass Wellenspannungssignale und/oder Wellenstromsignale einer Analyseeinheit zugeführt werden, wobei die Analyseeinheit eine kombinierte und simultane Analyse von wenigstens zwei potenziellen Fehlerzuständen der elektrischen Maschine erlaubt.

Der Kern der Erfindung besteht somit einerseits darin, festzustellen, dass die Messung von Wellenspannung und/oder Wellenstrom Aussagen über unterschiedlichste Verhaltensweisen resp. Fehlerzustände einer elektrischen Maschine erlaubt. Wird entsprechend die Analyseeinheit so modifiziert, dass sie in der Lage ist, kombiniert und simultan die für unterschiedliche Fehlerzustände charakteristischen Signale aufzuzeichnen, so erhält man ein Kombinationsmessgerät, welches mit den bereits üblicherweise vorhandenen Elementen (Erdung auf der einen Seite des Generators und Einheit zur Messung von Wellenspannung auf der anderen Seite des Generators) betrieben werden kann. Ein derartiges Kombinationsmessgerät, bei welchem mehrere Fehlerzustände gleichzeitig simultan auf Basis einer Messung und damit gewissermassen eines einzigen Datensatzes erfasst werden können, erlaubt eine wesentlich detailliertere Analyse der Signale, mit verbesserten Möglichkeiten der kombinierten Interpretation von unterschiedlichen Effekten. So können, im Gegensatz zu der Situation von einzelnen Messgeräten zu jedem Fehlerzustand nach dem Stand der Technik, in einem derartigen Gerät Simultan-Querbeziehungen zwischen den einzelnen Phänomenen/Messresultaten hergestellt und untersucht werden, dies ohne Abgleich zwischen unterschiedlichen Geräten. So gibt es eine Vielzahl von Fehlerzuständen und Abnormalitäten, welche für sich alleine betrachtet gegebenenfalls noch keine kritische Situation kennzeichnen, die aber, wenn zusätzlich ein weiterer anderer Fehlerzustand auftritt, ein Zeichen für einen kritischen Zustand sein können. So kann es bei der konventionellen Methode, bei welcher individuelle Fehlerzustände in unkoordinierter Weise betrachtet werden, vorkommen, dass die Anlage angehalten wird, obwohl dies noch nicht wirklich notwendig wäre. Das vorgeschlagene Kombinationsmessgerät kann hingegen wesentlich zuverlässigere Diagnosen von Fehlerzuständen ermöglichen. Ein derartiges Kombinationsmessgerät weist vor allem den grossen Vorteil auf, dass die Korrelation zwischen unterschiedlichen Fehlerzuständen auch automatisiert erfolgen kann, und gezielte Warnmeldungen (Alerts) erlaubt. Im Gegensatz zum Stand der Technik können nicht nur Spitzenwerte und Mittelwerte verwendet werden, sondern tatsächlich Messungen im Frequenz- und im Zeitbereich über das gesamte Spektrum des Signals, d.h. im niederfrequenten als auch im hochfrequenten Bereich gleichzeitig.

Die dabei betrachteten Wellenspannungen respektive Wellenströme kommen unter anderem aufgrund magnetischer Asymmetrien der Umgebung der Generatorwelle, aufgrund von elektrostatischen Aufladungen der Generatorwelle, aufgrund von äusseren elektrischen Feldern, die Wellenspannungen kapazitiv in die Generatorwelle einkoppeln, oder aufgrund von magnetischen Remanenzen in der rotierenden Welle, z.B. aufgrund von Restmagnetisierung der Welle, zu Stande.

Die Wellenspannungen und Wellenströme stellen grundsätzlich ein Gefahrenpotenzial für verschiedene Komponenten des Generators dar und können zu Schäden am Generator führen, wenn sie entweder nicht auf ein tolerierbares Mass reduziert werden, oder aber das Erdungskonzept des Wellenstranges nicht geeignet ist. Hierzu wurden in der Vergangenheit an der Generatorwelle spezielle Vorkehrungen getroffen, indem beispielsweise auf der Nichtantriebsseite des Generators Isolierstrecken eingebaut und auf der Antriebsseite die Generatorwelle über Bürsten mit dem Erdpotential verbunden wurde. Um Spannungsspitzen zu verkleinern, wird oft die Generatorwelle an der Nichtantriebsseite mittels eines Gleitkontaktes über eine Kapazität wechselspannungsmässig an das Erdpotential angekoppelt.

Ein weiterer Kern der Erfindung besteht auch in der durchaus überraschenden Erkenntnis, dass der Wellenstrom respektive die Wellenspannung nicht nur die obengenannte Information gemäss der EP-A1-0 271 678 über die Funktionstüchtigkeit und die Funktionssicherheit der Wellenerdung oder auch die Information gemäss der ausserdem zu nennenden EP-A2-0 391 181 über Rotorwindungsschlüsse enthält, sondern dass in diesen Signalen ausserdem umfangreiche Information über weitere Fehlerzustände verborgen ist, und dass diese in einer einzigen Analyseeinheit synchron ausgewertet werden können. Entsprechend ist es zum Beispiel möglich, auf üblicherweise für die Messung von Schwingungen speziell vorzusehende Vorrichtungen zu verzichten, und Wellenspannung respektive Wellenstrom mit den gegebenenfalls bereits vorhandenen Geräten zur Überwachung der Funktionstüchtigkeit oder der Rotorwindungsschlüsse zu messen und aus den dabei erhaltenen Daten Rückschlüsse über Schwingungen der Welle gleichzeitig mit anderen Fehlerzuständen zu machen. Die Messung von Wellenstrom und/oder Wellenspannung ist dabei eine hinreichend genaue und speziell für Langzeitbeobachtungen sehr geeignete Methode zur Ermittlung von Fehlerzuständen.

Bei den über diese Analyseeinheit über die Messung von Wellenspannung und/oder Wellenstrom zugänglichen Fehlerzuständen handelt es sich um wenigstens zwei verschiedene Fehlerzustände ausgewählt aus der folgenden Gruppe: Windungsschlüsse in der Rotorwicklung; Funktionsschwäche der Wellenerdung sowie Isolationsschwäche der Welle; Isolationsschwäche der Rotorwicklung; Funkenerosion der Welle; Bürstenfeuer, insbesondere an den Schleifringen; Teilentladungen im Stator und oder im Rotor und/oder in der Erregervorrichtung; Schwingungen der Welle, insbesondere Torsionsschwingungen, und/oder Biegeschwingungen und/oder Pendelungen; Funken in der Erregervorrichtung und/oder der Rotorwicklung; drehsynchrone Rattermarken und/oder Streifstellen. Erstaunlicherweise sind alle diese Fehlerzustände über eine derartige Messung zugänglich und es können insbesondere jeweils Paare oder ganze Gruppen von diesen Fehlerzuständen synchron und koordiniert beobachtet werden. Bevorzugt handelt es sich bei wenigstens einem der Fehlerzustände um hochfrequente Funkenaktivität wie z.B. Funkenerosion an der Welle oder Funken in der Erregervorrichtung und/oder der Rotorwicklung, oder um gefährdende Schwingungen der Welle wie z. B. transversale Biegeschwingungen, Pendelungen oder Torsionsschwingungen. Diese Kombinationen lassen besonders aussagekräftige gemeinsame Analysen zu.

Eine bevorzugte Ausführungsform der erfindungsgemässen Vorrichtung ist dadurch gekennzeichnet, dass an der ersten Seite des Generators zur Erdung der Welle eine Erdungseinheit vorgesehen ist, welche ihrerseits die Messung von Wellenspannung und/oder Wellenstrom als Funktion der Zeit erlaubt. Auch diese Signale (Messwerte) werden der Analyseeinheit zugeführt, in der Analyseeinheit kombiniert und simultan mit den Signalen aus der Messeinheit ausgewertet. Die zusätzliche Messung auf der zweiten Seite des Generators (oder im Falle von mehreren Generatoren an unterschiedlichen Stellen zwischen diesen Generatoren) mittels der Messeinheit erlaubt eine effektive Lokalisierung von Fehlerzuständen entlang der Welle. So kann z.B. auf diese Weise festgestellt werden, bei welchem Lager tatsächlich Funkenerosion auftritt, da das differenzielle Verhalten der beiden Messwerte von Erdungseinheit und Messeinheit entsprechende Rückschlüsse zulässt.

Eine weitere bevorzugte Ausführungsform der Vorrichtung zeichnet sich dadurch aus, dass die Analyseeinheit sowohl im niederfrequenten als auch im hochfrequenten Signalbereich auswertet. Dabei verfügt die Analyseeinheit insbesondere bevorzugt über Mittel, mit welchen die eingehenden Signale frequenzselektiv gefiltert werden können. Die unterschiedlichen Fehlerzustände erzeugen Signalkomponenten in unterschiedlichen Frequenzbereichen. Es kann z.B. nützlich sein, simultan und kombiniert den niederfrequenten Bereich bevorzugt mittels Fourieranalyse zur Ermittlung von Windungsschlüssen und/oder gefährdenden Schwingungen der Welle zu verwenden und den hochfrequenten Bereich zur Ermittlung von Funkenaktivität.

Entsprechend erweist es sich als vorteilhaft, unter anderem zur Verbesserung der Trennung von unterschiedlichen Phänomenen und zur Erhöhung des Signal-zu-Rauschverhältnisses, die eingehenden Signale der Analyseeinheit zu filtern. Dabei kann es sich bei den Mitteln um einen Tiefpass-Filter und um einen Hochfrequenz-Bandpass-Filter handeln, durch welche die eingehenden Signale (Signal von Wellenspannung respektive Wellenstrom von Messeinheit respektive Erdungseinheit) entweder gleichzeitig oder in geschalteter Weise alternativ gefiltert werden. Die Mittel können entweder als passive Filter ausgestaltet sein, es ist aber auch möglich, frequenzselektive Verstärker zu verwenden. Es wird bevorzugt der Tiefpass für Frequenzen unterhalb von 20 kHz durchlässig gestaltet und der Hochfrequenz-Bandpass in bevorzugt einstellbarer Weise für Frequenzen im Bereich von 20 kHz bis 40 MHz, insbesondere bevorzugt von 1 MHz bis 40 MHz, durchlässig gestaltet.

Eine weitere bevorzugte Ausführungsform der vorliegenden Erfindung weist das Merkmal auf, dass der Analyseeinheit zusätzlich weitere, nicht auf der Messung von Wellenspannung und/oder Wellenstrom beruhende Daten oder Signale über Fehlerzustände zugeführt werden, und diese kombiniert und simultan mit der Wellenspannung und/oder dem Wellenstrom in Bezug auf Fehlerzustände überwacht respektive analysiert werden. Derartige zusätzliche Daten oder Signale können z.B. in Messsignalen der Teilentladungsmessungen an den Stator-Phasenwicklungen oder Messungen von Funkenaktivität an den Schleifring-Bürsten bestehen. Werden diese zusätzliche Daten oder Signale, welche über andere Mechanismen erfasst werden, ebenfalls der Analyseeinheit zugeführt, so können weitere Korrelationen zwischen Fehlerzuständen festgestellt und zur Diagnose verwendet werden.

Die Auswertung in der Analyseeinheit erfolgt gemäss einer weiteren Ausführungsform der Erfindung als Abtastung, insbesondere bevorzugt unter Verwendung eines Analog-Digital-Wandlers (ADC), bevorzugt mit einer Abtastrate, die der Netzfrequenz entspricht oder ganzzahligen Vielfachen der Netzfrequenz geteilt durch die Polpaarzahl des Generators. In der Analyseeinheit kann zur Analyse von Wellenspannung und/oder Wellenstrom das entsprechende Signal in Bezug auf darin enthaltene Frequenzmodulationen und/oder Amplitudenmodulationen und/oder Frequenzlinien insbesondere im Basisband untersucht werden. Dabei können auch transiente Vorgänge im Spektrum ausgewertet werden. Vorteilhafter Weise findet die Auswertung der Signale mit Hilfe einer Fouriertransformation statt. Dies, indem gegebenenfalls nach Demodulation oder Heruntermischen des Signals mit einer Trägerfrequenz, z.B. mit der Netzfrequenz und/oder deren ganzzahligen Harmonischen geteilt durch die Anzahl der Polpaare, abschnittsweise fouriertransformiert wird, und das resultierende Spektrum auf Linienverbreiterungen und/oder auf Seitenbänder und/oder auf Frequenzlinien im Basisband analysiert wird. Dabei wird üblicherweise das Signal mit einer Abtastrate von 1-200 kHz, insbesondere für die niederfrequenten Anteile im Bereich von 5 kHz abgetastet, und für die hochfrequenten Anteile im Bereich von 200 kHz abgetastet. Anschliessend werden für die Ermittlung von Feinstrukturen vom Signal jeweils Abschnitte im Bereich von 0.5k bis 1000k Datenpunkte, insbesondere im Bereich von 64k Datenpunkte fouriertransformiert.

Eine weitere bevorzugte Ausführungsform der vorliegenden Erfindung zeichnet sich dadurch aus, dass an der ersten Stelle eine Erdungseinheit (Driving end module) vorgesehen ist, welche über einen hochohmigen Widerstand zur Kontaktvorrichtung an die Welle und über einem niederohmigen Widerstand zur Erde verfügt, wobei parallel zum hochohmigen Widerstand eine Sicherung angeordnet ist, und wobei insbesondere bevorzugt zwischen Erde und niederohmigem Widerstand ein Messwiderstand angeordnet ist, wobei die Wellenspannung zwischen hochohmigem Widerstand und Kontaktvorrichtung und Erdanschluss, und der Wellenstrom über dem Messwiderstand abgegriffen wird. Die Messeinheit wird ihrerseits bevorzugt wie folgt ausgestaltet. Sie verfügt über eine Sicherung zur Kontaktvorrichtung an die Welle und über eine oder mehrere parallel angeordnete Kapazitäten sowie parallel dazu über einen Widerstand zur Erde. Dabei ist zwischen Erde und Kapazität respektive Widerstand ein Messwiderstand angeordnet, wobei die Wellenspannung zwischen Sicherung und Erdanschluss und der Wellenstrom über dem Messwiderstand abgegriffen werden. Diese Art der Messung erlaubt eine störungsfreie und infolge der vorhandenen Sicherungen vor Spannungsspitzen und Stromspitzen gesicherte Beobachtung.

Weitere bevorzugte Ausführungsformen der erfindungsgemässen Vorrichtung sind in den abhängigen Ansprüchen beschrieben.

Des Weiteren betrifft die vorliegende Erfindung ein Verfahren zur Überwachung und/oder Analyse von elektrischen Maschinen im Betrieb, wobei die elektrische Maschine wenigstens einen Generator mit einer Welle sowie Antriebsmittel zum Antrieb dieser Welle umfasst, wobei die Welle an der ersten Seite des Generators niederohmig geerdet ist und wobei an der Welle an der zweiten Seite des Generators eine Messeinheit zur Messung von Wellenspannung und/oder Wellenstrom als Funktion der Zeit vorgesehen ist. Dabei werden Signale von Wellenspannung und/oder Wellenstrom einer Analyseeinheit zugeführt, und in der Analyseeinheit erfolgt eine kombinierte und simultane Analyse im Hinblick auf wenigstens zwei potenzielle Fehlerzustände der elektrischen Maschine. Bevorzugt handelt es sich dabei um die weiter oben genannten Fehlerzustände, und das Verfahren wird bevorzugtermassen unter Verwendung einer Vorrichtung, wie sie oben beschrieben ist, durchgeführt.

Weitere bevorzugte Ausführungsformen des erfindungsgemässen Verfahren sind in den abhängigen Ansprüchen beschrieben.

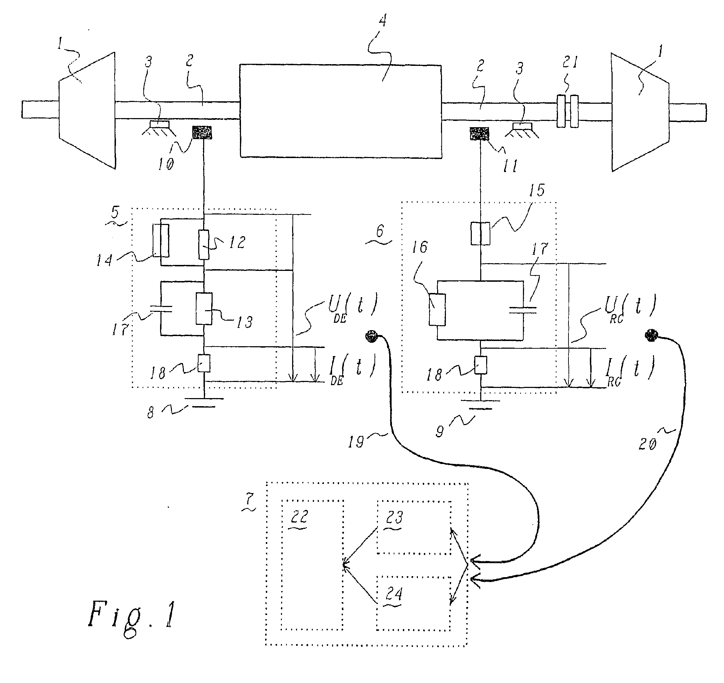

### KURZE ERLÄUTERUNG DER FIGUR

Die Erfindung soll nachfolgend anhand von Ausführungsbeispielen im Zusammenhang mit der Zeichnung näher erläutert werden. Die einzige Figur zeigt eine schematische Darstellung einer Vorrichtung zur Messung von Wellenspannung U_{RC}(t) und/oder U_{DE}(t) respektive Wellenstrom I_{RC}(T) und/oder I_{DE}(T) als Funktion der Zeit (t).

### WEGE ZUR AUSFÜHRUNG DER ERFINDUNG

Die Figur zeigt eine schematische Darstellung einer Gasturbinenanlage, bei welcher als Antriebsmittel zwei Turbinen 1 auf den beiden Seiten eines Generators 4 angeordnet sind, wobei die beiden Turbinen 1 wie auch der Generator 4 auf einer gemeinsamen Welle 2 bzw. einem Wellenstrang angeordnet sind. Die zwei Turbinen sind dabei nur beispielhaft zu verstehen, es ist auch möglich, dass nur eine Turbine angeordnet ist. Um den Generator 4 z.B. beim Hochfahren von den Turbinen 1 trennen zu können, sind üblicherweise Kupplungen vorgesehen, welche eine mechanische Entkopplung der Turbinen 1 vom Generator 4 erlauben.

Die Welle 2 ist auf wenigstens zwei Wellenlagern 3 gelagert. Die in den Lagern 3 vorliegenden Ölfilme isolieren die Welle 2 elektrisch von den mit der Erde in Verbindung stehenden Lagern 3. Diese Isolation kann aber bei Spannungsspitzen ab einer bestimmten Höhe zusammenbrechen, was zu Problemen mit Elektroerosion führen kann (Funkenerosion der Welle).

Wie bereits eingangs erwähnt, treten an einer derartigen Welle eines Generators 4 aus verschiedenen Gründen Wellenspannungen und Wellenströme auf, deren Frequenzspektrum vom Gleichwert bis zu Frequenzen reicht, die als Vielfache mit der Rotationsfrequenz des Generators, aber auch mit den Frequenzen eines statischen Erregungssystems des Generators zusammenhängen. Es können Frequenzen bis zu mehreren MHz auftreten.

Die Wellenspannungen respektive Wellenströme kommen unter anderem aufgrund magnetischer Asymmetrien der Umgebung der Welle 2, aufgrund von elektrostatischen Aufladungen der Welle 2, aufgrund von äusseren elektrischen Feldern, die Wellenspannungen kapazitiv in die Welle 2 einkoppeln, oder aufgrund von magnetischen Remanenzen in der rotierenden Welle 2, sowie aufgrund von Restmagnetisierung (herstellungsbedingt) der Welle 2 zu Stande.

Die Wellenspannungen, im folgenden als U(t) bezeichnet, und Wellenströme, im folgenden als I(t) bezeichnet, stellen grundsätzlich eine Gefahr für verschiedene Komponenten des Generators dar und können zu Schäden am Generator führen. Erfindungsgemäss wird nun aber die Wellenspannung respektive der Wellenstrom zur gezielten Analyse und Erfassung von diversen Fehlerzuständen einer elektrischen Maschine verwendet.

Dazu wird auf der einen Seite des Generators 4 eine niederohmige Erdungseinheit, z.B. ein so genanntes DE-Modul 5 (Driving End Module) an der Welle 2 angeschlossen, welches im wesentlichen eine gesicherte niederohmige Erdung der Welle 2 gewährleistet. Das DE-Modul 5 ist mit der Analyseeinheit 7 verbunden.

Auf der anderen Seite des Generators 4 wird als Messeinheit zur Messung von Wellenspannung (U_{RC}(t)) und/oder Wellenstrom (I_{RC}(t)) als Funktion der Zeit eine höherohmige Erdungseinrichtung, ein so genanntes RC-Modul 6 (R für Widerstand, C für Kapazität), welches mit der Analyseeinheit 7 verbunden ist, einerseits mit der Welle 2 verbunden und andererseits zum Erdungspunkt 9 verbunden.

Das DE-Modul 5 ist über eine Kontaktvorrichtung 10 mit der Welle 2 verbunden. Bei der Kontaktvorrichtung 10 handelt es sich vorzugsweise um ein Cu-Geflecht, welches schleifend mit der Welle 2 in elektrischem Kontakt steht. Das DE-Modul 5 ist niederohmig zum Erdungspunkt 8 ausgebildet, indem zwischen Kontaktvorrichtung 10 und Erdungspunkt 8 zunächst ein hochohmiger Widerstand 12 und parallel zu diesem hochohmigen Widerstand 12 eine Sicherung 14 geschaltet ist. Dies um zu verhindern, dass zu hohe Ströme auftreten. Damit gewährleistet das DE-Modul 5 zunächst eine niederohmige Erdung der Welle 2. In Serie zu diesem hochohmigen Widerstand 12 respektive zur Sicherung 14 zur Erde ist ein niederohmiger Widerstand 13 geschaltet. Typischerweise weist der Widerstand 13 einen Wert R im Bereich von 1 bis 10 Ohm auf. Um weiterhin hochfrequente Spannungsspitzen (typischerweise 150-200 kHz) kurzschliessen zu können, ist parallel zum niederohmigen Widerstand ein Kondensator 17 mit einer Kapazität C im Bereich von 3 - 10 µF angeordnet. Ansonsten besteht die Gefahr, dass derartige Spannungsspitzen über die Lagerschalen abgebaut werden und dort zu Funkenbildung führen.

Zwischen hochohmigem Widerstand 12 und der Kontaktvorrichtung 10 respektive der Erde wird die Wellenspannung U_{DE}(t) als Funktion der Zeit abgegriffen, und über ein Koaxialkabel 19 der Analyseeinheit 7 übergeben. Um den Zustand der Sicherung 14 zu überwachen, ist es möglich, auch gleichzeitig die Spannung zwischen den Widerständen 12 und 13 respektive der Erde zu überwachen. Zwischen der Erde und dem niederohmigen Widerstand 13 befindet sich ausserdem ein Messwiderstand 18 (shunt resistance), bei welchem über den darüber auftretenden Spannungsabfall der Wellenstrom I_{DE}(t) berechnet und mitgeschrieben werden kann. Auch diese Information wird über das Koaxialkabel 19 an die Analyseeinheit 7 übergeben.

Auf der anderen Seite des Generators 4 ist üblicherweise zur Ableitung von Spannungs-Spitzen das RC-Modul 6 angeordnet. Dieses verfügt ebenfalls zur Welle 2 über eine Kontaktvorrichtung 11, welche wiederum bevorzugt in Form eines Cu-Geflechts, welches in elektrischem Kontakt mit der Welle 2 steht, ausgebildet ist. Das RC-Modul 6 weist zunächst zur Welle eine Sicherung 15 auf, üblicherweise eine Sicherung des Typs 2AT (auch hier dient die Sicherung zum Schutz vor hohen Strömen), und in Serie dazu einen Widerstand 16, zu welchem parallel eine als Kondensator ausgebildete Kapazität 17 angeordnet ist. Ganz allgemein weist der parallel zur Kapazität 17 angeordnete Widerstand 16 einen Wert R im Bereich von 100 bis 10000 Ohm auf, bevorzugt von 400 bis 1000 Ohm. Die Kapazität 17 weist einen Wert C typischerweise im Bereich von 1 bis 30 µF auf.

Zwischen Sicherung 15 und Erdungspunkt 9 wird nun die Wellenspannung U_{RC}(t) als Funktion der Zeit abgegriffen, und über ein Koaxialkabel 20 der Analyseeinheit 7 übergeben. Zwischen dem Erdungspunkt 9 und der parallelen Anordnung von Widerstand 16 und Kapazität 17 befindet sich ausserdem wiederum ein Messwiderstand 18 (shunt resistance), bei welchem über den darüber auftretenden Spannungsabfall der Wellenstrom I_{RC}(t) berechnet und mitgeschrieben werden kann. Auch diese Information wird über das Koaxialkabel 20 an die Analyseeinheit 7 übergeben.

Die gemessene Wellenspannung als Funktion der Zeit, U_{RC}(t), U_{DE}(t), respektive der gemessene Wellenstrom als Funktion der Zeit, I_{RC}(t), I_{DE}(t), enthält nun Informationen über diverse Fehlerzustände der elektrischen Maschine, welche im Folgenden beispielhaft aufgelistet werden sollen:
A) Windungsschlüsse in der Rotorwicklung:
   Derartige Windungsschlüsse führen, wie in der US 5,006,769 beschrieben, zu charakteristischen harmonischen Komponenten im Signal von Wellenspannung respektive Wellenstrom. Die Signale bewegen sich im Bereich von unterhalb 1 kHz, das heisst im niederfrequenten Bereich, und treten bei den geradzahligen Vielfachen der Rotordrehfrequenz auf. Bei einer Rotationsfrequenz von 50 Hz werden entsprechend charakteristische Signale bei 100 Hz, 200 Hz beobachtet, sofern Windungsschlüsse in der Rotorwicklung tatsächlich vorliegen. Ohne Vorliegen von Windungsschlüssen werden bei diesen Frequenzen nur schwache Signale beobachtet.
B) Erdungszustand der Welle respektive Isolationszustand der Welle:
   Das Vorliegen von diesen Fehlerzuständen wird im Zeitbereich beobachtet und äussert sich in charakteristischen Unterbrüchen des Signals, üblicherweise im Bereich von 1 bis 6 ms. Die auftretenden charakteristischen Signale sind in der EP 271678 A1 beschrieben, und dort ist ebenfalls angegeben, wie aus diesen Signalen gezielte Diagnosen möglich sind. Insbesondere die Kombination des Messwerts der Wellenspannung über DE-Modul 5 und RC-Modul 6 lässt eine genauere Lokalisierung des entsprechenden Fehlerortes zu.
C) Isolationszustand der Rotorwicklung:
   Ein Fehlerzustand führt hier zu einem niederfrequenten Signal im Bereich von weniger als 1 kHz. Ähnlich wie beim Windungsschluss der Rotorwicklung werden charakteristische Vielfache der Netzfrequenz beim Vorliegen einer fehlerhaften Isolation der Rotorwicklung sichtbar. Bei einer Netzfrequenz von 50 Hz beobachtet man spezielle Bänder bei 300 Hz, 600 Hz, 900 Hz, etc., entsprechend bei einer 6-pulsigen Spannung Bänder bei 150
   Hz, 300 Hz, etc.
D) Funkenerosion der Welle:
   Tritt dieser Fehlerzustand auf, so beobachtet man charakteristische Signale im hochfrequenten Bereich, d. h. ab ca. 500 kHz. Man beobachtet im Zeitsignal von Wellenspannung respektive Wellenstrom starke Ausschläge (Spikes), typischerweise bei 1.5 MHz oder 40MHz etc. Die Ausschläge ähneln dabei den bei Teilentladungen auftretenden Pulsen.
E) Bürstenfeuer an den Schleifringen:
   Auch hier führt das Vorliegen dieses Fehlerzustandes zu charakteristischen, hochfrequenten Ausschlägen des Signals (vgl. dazu die eingangs genannten Dokumente des Standes der Technik, die entsprechenden Signale, welche man über die Wellenspannung respektive den Wellenstrom beobachtet, sind den in diesen Dokumenten genannten analog). Die beobachteten Signale liegen aber in anderen Bandbereichen als jene, welche bei Funkenerosion beobachtet werden.
F) Teilentladungen im Stator/Rotor/Erreger:
   Treten derartige Teilentladungen auf, so beobachtet man Ausschläge (Spikes) in einem Frequenzbereich wesentlich oberhalb von 500 kHz. Im wesentlichen handelt es sich bei den über die Wellenspannung respektive den Wellenstrom beobachteten Signale um Signale, die zu jenen, die in der eingangs genannten US 4,814,699 beschrieben sind, analog sind.
G) Wellenvibrationen:
   Es handelt sich dabei um Vibrationen wie transversale Biegeschwingungen der Welle 2 (Bewegung Typ I), um Pendelungen der Welle 2 (Bewegung Typ II), oder um Torsionsschwingungen der Welle 2 (Bewegung Typ III). Pendelungen sind in diesem Zusammenhang Änderungen der Rotationsgeschwindigkeit des Rotors um die eigentliche Nennfrequenz herum. Sie kommen z.B. zu Stande, wenn im Netz, welches üblicherweise bei 50 oder 60 Hz betrieben wird, Störungen auftreten, welche in die Bewegung des Rotors einkoppeln und diese z.B. verlangsamen. Dies führt zu einer Pendelung der Rotorfrequenz um die Nennfrequenz herum, was insbesondere dann kritisch werden kann, wenn es sich bei dieser Pendelung um eine Eigenfrequenz des Systems handelt, da dann ein Aufschaukeln möglich wird Torsionsschwingungen treten z.B. dann auf, wenn am Netz eine plötzliche Lasterhöhung auftritt, und durch diese Lasterhöhung der Generator gewissermassen kurz abgebremst wird (was natürlich auch wieder Pendelungen bewirkt).
   Die Auswertung von Wellenstrom respektive Wellenspannung erlaubt die Diagnose von allen drei Bewegungstypen I, II, respektive III. Zur Messung von Torsionsschwingungen (Typ III) und Pendelungen (Typ II) können dabei bevorzugt Verfahren zur Frequenzdemodulation verwendet werden, welche unempfindlich gegenüber Amplitudenschwankungen sind. Zur Messung von Biegeschwingungen (Typ I) können Verfahren zur Amplitudendemodulation verwendet werden. In beiden Fällen können dabei eine Vielzahl von Harmonischen des Wellensignals verwendet werden.
   Biegeschwingungen (Typ I) äussern sich im entsprechenden Spektrum einerseits als Seitenbänder der Wellenspannungs/strom-Harmonischen, wobei die Seitenbänder um die Modulationsfrequenz beabstandet sind. Dies ergibt sich daraus, dass diese Art von Schwingungen Amplitudenmodulationen des Signals U(t) respektive I(t) hervorrufen, wobei die Modulationsfrequenz etwa 1 bis 300 Hz betragen kann, und diese Modulationen sowohl auf der Grundharmonischen der Wellenspannung/des Wellenstroms, als auch auf den entsprechenden Harmonischen sichtbar ist. Biegeschwingungen sind so durch einfache Betrachtung respektive Analyse von Linien respektive von deren Seitenbändern möglich. Diese Analyse ist visuell möglich aber auch automatisiert. Ausserdem äussern sich Biegeschwingungen auch als Frequenzlinien im Basisband, d. h. " Seitenbänder " um 0 Hz. Pendelschwingungen (Typ II) finden üblicherweise um die Grundfrequenz des Rotors statt. Es handelt sich dabei um schnelle Änderungen der Rotationsfrequenz, d. h. um Änderungen auf einer Zeitskala von weniger als 1 sec. Dies führt im Fourierspektrum zu einer Linienverbreiterung auf der Linie der Rotationsfrequenz sowie auf den Harmonischen. Dabei handelt es sich um Verbreiterungen respektive um ein Schieben der Frequenz im Bereich von 3-4 Promille. Entsprechend kann das Auftreten von Pendelungen an derartigen Linienverbreiterungen visuell oder automatisiert erkannt werden, und insbesondere kann deren Auftreten in zeitlicher Abfolge analysiert werden.
   Torsionsschwingungen (Typ III) führen aufgrund der üblicherweise hohen Frequenzen zu Feinstrukturen im Spektrum. Torsionsschwingungen liegen üblicherweise im Bereich von 100 bis 200 Hz und führen zu sehr schnellen Frequenzverschiebungen respektive Phasenverschiebungen auf dieser Zeitskala. Auch diese können wiederum visuell oder automatisch im Spektrum erkannt und analysiert werden.
H) Funken in der Erregereinrichtung oder der Rotorwicklung:
   Auch hier werden hochfrequente charakteristische Signale beobachtet.
I) Drehsynchrone Rattermarken und/oder Streifstellen:
   Derartige Rattermarken treten auf, wenn z.B. die Lagerschale streift. Unter Streifstellen werden elektrische Streifstellen verstanden. Diese Fehlerzustände äussern sich in Signalen im niederfrequenten wie auch im hochfrequenten Bereich. Streifstellen werden z.B. im niederfrequenten Bereich beobachtet, während aber auch periodische Funken in bestimmten Bereichen im hochfrequenten Frequenzbereich beobachtet werden können.

Entscheidend ist nun, dass diese unterschiedlichen Phänomene, die nach dem Stand der Technik von verschiedenen Messgeräten und Ankopplungseinheiten gemessen werden, in einer einzigen Analyseeinheit 7, primär anhand der Wellenspannung, analysiert werden können, und so Querbeziehungen zwischen den einzelnen Messresultaten einfach hergestellt und untersucht werden können. Dabei wird die Wellenspannung sowohl im niederfrequenten als auch im hochfrequenten Signalbereich gemessen. Dies ist besonders vorteilhaft, weil manche Phänomene erst in Verbindung mit anderen Phänomenen klare Aussagen erlauben und erst wenn in Kombination auftretend eine Maschinengefährdung darstellen. Beispielsweise wird ein Windungsschluss erst dann betriebsstörend, wenn gleichzeitig auch stärkere Vibrationen auftreten. Die Simultanmessung erweist sich so als sehr vorteilhaft, da Korrelationen erkannt werden können.

Für die Analyse werden Algorithmen verwendet, die zur Feststellung der obengenannten Fehlerzustände dienen. Einige Algorithmen verwenden Signale sowohl aus dem niederfrequenten wie auch aus dem hochfrequenten Signalbereich (z.B. zur Detektion von Streifstellen, Isolation der Welle). Ausserdem verwenden manche Algorithmen auch Ergebnisse der anderen Messalgorithmen und setzen diese zueinander in Beziehung, um die Aussagekraft der Diagnose zu erhöhen. Durch die (Simultan)-Kombination mehrerer Messverfahren werden bessere und aussagekräftigere Resultate erzielt als durch die Summierung aller Einzelverfahren alleine. Beispielhaft sollen dazu folgende spezifische Kombinationen dienen:
- Kombination von Vibrationsanalyse mit der simultanen Analyse auf Windungsschluss im gleichen Gerät. Dies ist vorteilhaft, da Windungsschlüsse erst dann betriebsstörend sind, wenn sie Vibrationen verursachen.
- Kombination von Vibrationsanalyse mit Analyse auf Streifstellen der Welle. Wenn eine Vibration zu einer Streifstelle oder umgekehrt führt, was an einem entsprechenden simultanen Auftreten der beiden charakteristischen Signale erkennbar ist, so ist mit einer Gefährdung des Betriebs zu rechnen.
- Kombination der Messung der Hochfrequenz-Aktivität (Funkenerosion) auf der Welle mit der Messung der Streifstellen. Streifstellen für sich allein sind meist nicht kritisch. Ebenso kann eine Funkenerosion für sich allein unkritisch sein. Treten aber diese beiden Symptome gleichzeitig auf, so kann wiederum auf einen kritischen Betriebszustand geschlossen werden.
- Kombination der Vibrationsmessung an der Welle mit der Teilentladungsmessung der Statorwicklung. Wiederum können starke Vibrationen mit Teilentladungen kausal verbunden sein, und das synchrone Auftreten Anzeichen für einen kritischen Zustand darstellen.

Diese charakteristischen, kombiniert auftretenden Fehlerzustände können, da sie synchron in der einen Analyseeinheit 7 verwertet werden, auch sehr einfach einem automatisierten Erkennungsverfahren zugeführt werden, und entsprechende Warnmeldungen basierend auf kombinierten Werten können mit wesentlich erhöhter Zuverlässigkeit erzeugt werden.

Die eigentliche Analyseeinheit 7 umfasst zwei Eingangsstufen, eine Hochfrequenz-Eingangsstufe 23 und eine Niederfrequenz-Eingangsstufe 24. Die Hochfrequenz-Eingangsstufe 23 besteht aus einem Hochfrequenz-Bandpass (Empfangsband steilflankig und ab ca. 20 kHz bis in den MHz Bereich, vorzugsweise in der Frequenzweite einstellbar). Dieser beispielsweise über einen frequenzselektiven Verstärker realisierte Bandpass (Filter) 23 trennt Störsignale (z.B. Thyristorpulse) von Nutzsignalen (z.B. Signale von Funken). Im Durchlassband befindliche Nutzsignale werden detektiert, im Sperrbereich des Filters liegende Störsignale werden unterdrückt. Damit wird z.B. die Erkenntnis genutzt, dass die Thyristor-Schaltsignale eher niederfrequent sind im Vergleich zu den Funkensignalen des Bürstenfeuers. Ganz allgemein können verschiedene Phänomene durch Empfang in unterschiedlichen Frequenzbändern voneinander unterschieden werden.

Die Niederfrequenz-Eingangsstufe 24 ist für Frequenzen bis ca. 20 kHz ausgelegt. Wiederum kann es sich um einen passiven Tiefpass oder um einen selektiv niederfrequenten Verstärker handeln. Damit werden die Niederfrequenz-Signale aufbereitet.

Die Signale der Eingangsstufen werden anschliessend einer kombinierten Analyseeinheit 22 übergeben. Als besonders geeignet für die Analyse im Frequenzbereich erweist sich die Auswertung mit Hilfe einer Fouriertransformation des Zeitsignals U_{RC}(T) respektive U_{DE}(t) oder I_{RC}(T) respektive I_{DE}(t). Zur Erhöhung der Messgenauigkeit respektive zur Vereinfachung der Filterung der Eingangsdaten kann das entsprechende Zeitsignal mit einem Trägersignal (Carrier) respektive mit dem entsprechenden um π/2 geschobenen Trägersignal im Sinne einer Quadraturdetektion gemischt werden und in einem separaten Real- respektive ImaginärTeil gespeichert und fouriertransformiert (FFT) werden. Als Trägersignal eignet sich z.B. die Netzfrequenz, oder deren ganzzahlige Vielfache, welche dazu gegebenenfalls direkt vom Netz oder an einem geeigneten anderen Ort abgegriffen werden kann oder lokal erzeugt wird.

Das eingehende Signal U_{RC}(t) respektive U_{DE}(t) (typischerweise im Bereich von weniger als 15V) oder I_{RC}(T) respektive I_{DE}(t) wird zunächst in einem Analog-Digital-Wandler (ADC). mit einer Abtastrate von typischerweise 5 kHz (niederfrequente Signale aus der Niederfrequenz-Eingangsstufe 24) respektive 200 kHz (hochfrequente Signale aus der Hochfrequenz-Eingangsstufe 23) digitalisiert und anschliessend dieses digitalisierte Zeitsignal U^{dig}(t) respektive I^{dig}(t) abschnittsweise fouriertransformiert. Zur Analyse von z.B. Torsionen erweist sich dabei die Fouriertransformation von jeweils einem Fenster von z.B. 64k Datenpunkten als sinnvoll, bei der Untersuchung von z.B. Biegeschwingungen reicht üblicherweise bereits ein Fenster von 1k Datenpunkten, da die entsprechenden spektralen Merkmale wesentlich groberer Natur sind.

Das Signal kann ausserdem abgetastet werden mit einer Abtastrate, die der Netzfrequenz entspricht oder einem ganzzahligen Vielfachen der Netzfrequenz, geteilt durch die Polpaarzahl des Generators (netzphasensynchrone Analyse). Dies bewirkt eine Frequenzverschiebung um eben diese Abtastfrequenz. So können z.B. besonders einfach drehsynchrone Rattermarken oder Streifstellen detektiert werden.

In einer weiteren Ausführung wird die Messung an der Welle mit Teilentladungsmessungen an den Phasenklemmen, wie sie z.B. in der US 4,814,699 beschrieben ist, kombiniert. Damit ergibt sich die Möglichkeit, Impulse von Teilentladungen in der Statorwicklung von Funkenaktivitäten an der Welle zu unterscheiden, oder die Teilentladungsmessung zu ergänzen.

In einer weiteren Ausführung werden auch noch direkt an den Schleifring-Bürsten abgegriffene Signale (vgl. dazu US 3,653,019) in Bezug auf hochfrequente und niederfrequente Signale analysiert und ebenfalls mittels kombinierender Algorithmen zusammen mit den aus Wellenspannung respektive Wellenstrom erhaltenen Daten ausgewertet.

Grundsätzlich besteht jedoch ein grosser Vorteil der Auskopplung direkt an der Welle darin, dass die Messung aller Funkenaktivitäten an der Welle, z.B. Entladungen über die Lagerschalen, möglich wird. Die Messung beiderseits des Generators 4 erlaubt ausserdem eine gute Lokalisierung der auftretenden Phänomene.

Zu beachten ist in diesem Zusammenhang, dass sich die vorliegende Methode ganz besonders zur Langzeitbeobachtung des Verhaltens von Wellensträngen eignet, da der Geräteaufwand relativ klein ist und der Sensor, d. h. die Welle, immer vorhanden ist. So kann aus der graduellen langsamen Veränderung der Fehlerzustände einer elektrischen Maschine auf gegebenenfalls vorhandenen Revisionsbedarf geschlossen werden, und es können gezielt entsprechende Revisionen geplant und durchgeführt werden.

### BEZUGSZEICHENLISTE

- 1: Turbine, Antriebsmittel
- 2: Welle
- 3: Wellenlager
- 4: Generator
- 5: Erdungseinheit (DE-Modul, Driving End Module)
- 6: RC-Modul (hochohmig), Messeinheit
- 7: Analyseeinheit
- 8: Erdungspunkt von 5
- 9: Erdungspunkt von 6
- 10: Kontaktvorrichtung von 5
- 11: Kontaktvorrichtung von 6
- 12: hochohmiger Widerstand
- 13: niederohmiger Widerstand
- 14: Sicherung
- 15: Sicherung
- 16: Widerstand
- 17: Kapazität
- 18: Messwiderstand (Shunt resistance)
- 19: Koaxialkabel von 5 zu 7
- 20: Koaxialkabel von 6 zu 7
- 21: Schleifringe
- 22: kombinierte Analyseeinheit
- 23: Hochfrequenz-Bandpass (Hochfrequenz-Eingangsstufe)
- 24: Tiefpass (Niederfrequenz-Eingangsstufe)

## Patentansprüche

1. Vorrichtung zur Überwachung von elektrischen Maschinen mittels Messung von Wellenspannung (U_{RC} (t)) und/oder Wellenstrom (I_{RC}(t)) im Betrieb, wobei die elektrische Maschine wenigstens einen Generator (4) mit einer Welle (2) sowie Antriebsmittel (1) zum Antrieb dieser Welle (2) umfasst, wobei die Welle (2) an der ersten Seite des Generators (4) geerdet ist, wobei an der Welle (2) an der zweiten Seite des Generators (4) eine Messeinheit (6) zur Messung von Wellenspannung (U_{RC} (t)) und/oder Wellenstrom (I_{RC}(t)) als Funktion der Zeit vorgesehen ist, und wobei das Wellenspannungssignal (U_{RC} (t)) und/oder Wellenstromsignal (I_{RC} (t)) einer Analyseeinheit (7) zugeführt wird, **dadurch gekennzeichnet, dass** in der Analyseeinheit (7) mit dem Wellenspannungssignal (U_{RC} (t)) und/oder Wellenstromsignal (I_{RC} (t)) eine kombinierte und simultane Analyse auf wenigstens zwei potenzielle, mittels Messung von Wellenspannungssignal (U_{RC} (t)) und/oder Wellenstromsignal (I_{RC}(t)) ermittelbare Fehlerzustände der elektrischen Maschine durchgeführt wird, dass die Analyseeinheit (7) dazu vorgesehen ist, Wellenspannungssignal (U_{RC} (t)) und/oder Wellenstromsignal (I_{RC} (t)) sowohl im niederfrequenten als auch im hochfrequenten Signalbereich auszuwerten, wobei die Analyseeinheit (7) dazu vorgesehen ist, simultan und kombiniert den niederfrequenten Bereich zur Ermittlung von Windungsschlüssen und/oder gefährdenden Schwingungen der Welle zu verwenden und den hochfrequenten Bereich zur Ermittlung von Funkenaktivität, und wobei die Auswertung der Signale mittels Fouriertransformation stattfindet.

2. Vorrichtung nach Anspruch 1, **dadurch gekennzeichnet, dass** es sich bei den Fehlerzuständen um wenigstens zwei verschiedene Fehlerzustände ausgewählt aus der folgenden Gruppe handelt:
Windungsschlüsse in der Rotorwicklung; Funktionsschwächung der Wellenerdung; Isolationsschwäche der Welle (2); Isolationsschwäche der Rotorwicklung; Bürstenfeuer; Teilentladungen im Stator und oder im Rotor und/oder in der Erregervorrichtung; gefährdende Schwingungen der Welle (2); Funken in der Erregervorrichtung und/oder der Rotorwicklung; drehsynchrone Rattermarken und/oder Streifstellen.

3. Vorrichtung nach einem der vorhergehenden Ansprüche, **dadurch gekennzeichnet, dass** es sich bei wenigstens einem der Fehlerzustände um hochfrequente Funkenaktivität wie Funken in der Erregervorrichtung und/oder der Rotorwicklung, oder um gefährdende Schwingungen der Welle (2) wie transversale Biegeschwingungen, Pendelungen oder Torsionsschwingungen handelt.

4. Vorrichtung nach einem der vorhergehenden Ansprüche, **dadurch gekennzeichnet, dass** an der ersten Seite des Generators (4) zur Erdung der Welle (2) eine Erdungseinheit (5) vorgesehen ist, welche ihrerseits die Messung von Wellenspannung (U_{DE}(t)) und/oder Wellenstrom (I_{DE}(t)) als Funktion der Zeit erlaubt, und dass die Erdungseinheit (5) dazu vorgesehen ist, auch diese Signale (U_{DE} (t), I_{DE} (t)) der Analyseeinheit (7) zuzuführen, und diese in der Analyseeinheit (7) kombiniert und simultan mit den Signalen (U_{RC}(t),I_{RC} (t)) aus der Messeinheit (6) ausgewertet werden.

5. Vorrichtung nach einem der Ansprüche 1 bis 4, **dadurch gekennzeichnet, dass** die Analyseeinheit (7) insbesondere bevorzugt über Mittel (23, 24) verfügt, mit welchen die Signale (U_{RC} (t),I_{RC} (t),U_{DE}(t),I_{DE} (t)) frequenzselektiv gefiltert werden.

6. Vorrichtung nach Anspruch 5, **dadurch gekennzeichnet, dass** es sich bei den Mitteln um einen Tiefpass (24) und um einen Hochfrequenz-Bandpass (23) handelt, durch welche die Signale (U_{RC} (t), I_{RC} (t),U_{DE}(t),I_{DE}(t)) ent-weder gleichzeitig oder in geschalteter Weise gefiltert werden, wobei bevorzugt der Tiefpass (24) für Frequenzen unterhalb von 20 kHz durchlässig ist und der Hochfrequenz-Bandpass (23) für Frequenzen im Bereich von 20 kHz bis 40 MHz, insbesondere bevorzugt von 1 MHz bis 40 MHz, durchlässig ist.

7. Vorrichtung nach einem der vorhergehenden Ansprüche, **dadurch gekennzeichnet, dass** Mittel angeordnet sind, welche der Analyseeinheit (7) zusätzlich weitere, nicht auf der Messung von Wellenspannung und/oder Wellenstrom beruhende Signale über Fehlerzustände zuführen, und diese kombiniert und simultan mit der Wellenspannung (U_{RC}(t),U_{DE}(t)) und/oder dem Wellenstrom (I_{RC} (t),I_{DE} (t)) in Bezug auf Fehlerzustände überwacht respektive analysiert werden.

8. Vorrichtung nach einem der vorhergehenden Ansprüche, **dadurch gekennzeichnet, dass** Analyseeinheit (7) dazu vorgesehen ist, die Auswertung als Abtastung durchzuführen, bevorzugt unter Verwendung eines Analog-Digital-Wandlers, wobei insbesondere bevorzugt eine Abtastrate, die der Netzfrequenz entspricht oder ganzzahligen Vielfachen der Netzfrequenz geteilt durch die Polpaarzahl des Generators, verwendet wird.

9. Vorrichtung nach einem der vorhergehenden Ansprüche, **dadurch gekennzeichnet, dass** in der Analyseeinheit (7) dazu vorgesehen ist, zur Analyse von Wellenspannung (U_{RC}(t), U_{DE} (t)) und/oder Wellenstrom (I_{RC} (t), I_{DE}(t)) das entsprechende Wellenspannungssignal respektive Wellenstromsignal (U_{RC} (t), I_{RC} (t), U_{DE} (t), I_{DE} (t)) in Bezug auf darin enthaltene Frequenzmodulationen und/oder Amplitudenmodulationen und/oder Frequenzlinien zu untersuchen.

10. Vorrichtung nach Anspruch 9, **dadurch gekennzeichnet, dass** die Analyseeinheit (7) zur Auswertung transienter Vorgänge im Spektrum ausgelegt ist.

11. Vorrichtung nach einem der Ansprüche 8, 9 oder 10, **dadurch gekennzeichnet, dass** die Analyseeinheit (7) dazu ausgelegt ist, gegebenenfalls nach Demodulation oder Heruntermischen des Wellenspannungssignals respektive Wellenstromsignals (U_{RC}(t),I_{RC} (t),U_{DE}(t),I_{DE} (t)) mit einer Trägerfrequenz, insbesondere mit der Netzfrequenz (ν _{Netz}) oder deren ganzzahligen Harmonischen geteilt durch die Anzahl der Polpaare des Generators, diese abschnittsweise zu fouriertransformieren, und das resultierende Spektrum auf Linienverbreiterungen und/oder auf Seitenbänder und/oder auf Frequenzlinien im Basisband zu analysieren.

12. Vorrichtung nach einem der Ansprüche 11 bis 13, **dadurch gekennzeichnet, dass** die Analyseeinheit (7) dazu ausgelegt ist, das Wellenspannungssignal respektive Wellenstromsignal mit einer Abtastrate von 1-200 kHz, insbesondere für die niederfrequenten Anteile im Bereich von 5 kHz abzutasten, und für die hochfrequenten Anteile im Bereich von 200 kHz abzutasten, und anschliessend für die Ermittlung von Feinstrukturen, vom Signal jeweils Abschnitte im Bereich von 0.5k bis 1000k Datenpunkte, insbesondere im Bereich von 64k Datenpunkte zu fouriertransformieren.

13. Vorrichtung nach Anspruch 4, **dadurch gekennzeichnet, dass** die Erdungseinheit (5) an der ersten Seite des Generators (4) zur einen Seite über einen hochohmigen Widerstand (12) zu einer Kontaktvorrichtung (10) an die Welle (2) und zur zweiten Seite über einen niederohmigen Widerstand (13) zum Erdungspunkt (8) verfügt, wobei parallel zum hochohmigen Widerstand (12) eine Sicherung (14) angeordnet ist, und wobei insbesondere bevorzugt zwischen Erdungspunkt (8) und niederohmigem Widerstand (13) ein Messwiderstand (18) angeordnet ist, wobei die Wellenspannung (U_{DE}(t)) zwischen hochohmigem Widerstand (12) und Kontaktvorrichtung (10) und Erdungspunkt (8), und der Wellenstrom (I_{DE} (t)) über dem Messwiderstand (18) abgegriffen wird.

14. Vorrichtung gemäss einem der vorhergehenden Ansprüche, **dadurch gekennzeichnet, dass** die Messeinheit (6) zur einen Seite über eine Sicherung (15) zu einer Kontaktvorrichtung (11) an die Welle (2) und zur anderen Seite über eine oder mehrere parallel angeordnete Kapazitäten (17) sowie parallel dazu über einen Widerstand (16) zum Erdungspunkt (9) verfügt, wobei zwischen Erdungspunkt (9) und Kapazität (17) sowie zwischen Erdungspunkt (9) und Widerstand (16) ein Messwiderstand (18) angeordnet ist, und wobei die Wellenspannung (U_{RC}(t)) zwischen Sicherung (15) und Erdungspunkt (9), und der Wellenstrom (I_{RC} (t)) über dem Messwiderstand (18) abgegriffen wird.

15. Verfahren zur Überwachung von elektrischen Maschinen mittels Messung von Wellenspannung (U_{RC} (t)) und/oder Wellenstrom (I_{RC}(t)) im Betrieb, wobei die elektrische Maschine wenigstens einen Generator (4) mit einer Welle (2) sowie Antriebsmittel (1) zum Antrieb dieser Welle (2) umfasst, wobei die Welle (2) an der ersten Seite des Generators (4) geerdet ist und wobei an der Welle (2) an der zweiten Seite des Generators (4) eine Messeinheit (6) zur Messung von Wellenspannung (U_{RC} (t)) und/oder Wellenstrom (I_{RC} (t)) als Funktion der Zeit vorgesehen ist, wobei das Wellenspannungssignal (U_{RC} (t)) und/oder Wellenstromsignal (I_{RC} (t)), einer Analyseeinheit (7) zugeführt werden, **dadurch gekennzeichnet, dass** in der Analyseeinheit (7) mit dem Wellenspannungssignal (U_{RC} (t)) und/oder Wellenstromsignal (I_{RC} (t)) eine kombinierte und simultane Analyse auf wenigstens zwei potenzielle, mittels Messung von Wellenspannungssignal (U_{RC}(t)) und/oder Wellenstromsignal (I_{RC}(t)) ermittelbare Fehlerzustände der elektrischen Maschine erfolgt, dass die Analyseeinheit (7) Wellenspannungssignal (U_{RC} (t)) und/oder Wellenstromsignal (I_{RC} (t)) sowohl im niederfrequenten als auch im hochfrequenten Signalbereich auswertet, wobei simultan und kombiniert der niederfrequente Bereich zur Ermittlung von Windungsschlüssen und/oder gefährdenden Schwingungen der Welle verwendet wird und der hochfrequente Bereich zur Ermittlung von Funkenaktivität, und wobei die Auswertung der Signale mittels Fouriertransformation stattfindet.

16. Verfahren gemäss Anspruch 15, **dadurch gekennzeichnet, dass** es sich bei den Fehlerzuständen um wenigstens zwei verschiedene Fehlerzustände ausgewählt aus der folgenden Gruppe handelt:
Windungsschlüsse in der Rotorwicklung; Funktionsschwäche der Wellenerdung; Isolationsschwäche der Welle (2); Isolationsschwäche der Rotorwicklung, Bürstenfeuer; Teilentladungen im Stator und/oder im Rotor und oder in der Erregervorrichtung; gefährdende Schwingungen der Welle (2); Funken in der Erregervorrichtung und/oder der Rotorwicklung; drehsynchrone Rattermarken und/oder Streifstellen,
und dass das Verfahren insbesondere bevorzugt unter Verwendung einer Vorrichtung gemäss einem der Ansprüche 1 bis 14 durchgeführt wird.

## Claims

1. Apparatus for monitoring of electrical machines by means of measurement of shaft voltage (U_{RC}(t)) and/or shaft current (I_{RC}(t)) during operation, wherein the electrical machine has at least one generator (4) with a shaft (2) and drive means (1) for driving this shaft (2), wherein the shaft (2) is grounded at the first end of the generator (4), wherein a measurement unit (6) for measurement of shaft voltage (U_{RC}(t)) and/or shaft current (I_{RC}(t)) as a function of time is provided on the shaft (2) at the second end of the generator (4), and the shaft voltage signal (U_{RC}(t)) and/or shaft current signal (I_{RC}(t)) is supplied to an analysis unit (7), **characterized in that** a combined and simultaneous analysis for at least two potential fault states, which can be determined by means of measurement of shaft voltage signal (U_{RC}(t)) and/or shaft current signal (I_{RC}(t)), in the electrical machine is carried out in the analysis unit (7) with the shaft voltage signal (U_{RC}(t)) and/or shaft current signal (I_{RC}(t)), **in that** the analysis unit (7) is provided for evaluating shaft voltage signal (U_{RC}(t)) and/or shaft current signal (I_{RC}(t)) both in the low-frequency and in the radio-frequency signal ranges, the analysis unit (7) being provided for using the low-frequency range, simultaneously and in a combined form, to determine turns shorts and/or dangerous oscillations of the shaft, and the radio-frequency range to determine spark activity, and the evaluation of the signals taking place by means of Fourier transformation.

2. Apparatus according to Claim 1, **characterized in that** the fault states are at least two different fault states selected from the following group:
turns shorts in the rotor winding; functional weakening of the shaft grounding; insulation weakness in the shaft (2); insulation weakness in the rotor winding; brush sparking; partial discharges in the stator and/or in the rotor and/or in the excitor apparatus; dangerous oscillations of the shaft (2); sparks in the excitation apparatus and/or the rotor winding; rotationally synchronous shattering marks and/or witness marks.

3. Apparatus according to one of the preceding claims, **characterized in that** at least one of the fault states is radio-frequency spark activity such as sparks in the excitation apparatus and/or in the rotor winding, or dangerous oscillations of the shaft (2) such as transverse bending oscillations, hunting or torsional oscillations.

4. Apparatus according to one of the preceding claims, **characterized in that** a grounding unit (5) is provided in order to ground the shaft (2) at the first end of the generator (4), and itself allows the measurement of the shaft voltage (U_{DE}(t)) and/or shaft current (I_{DE}(t)) as a function of time, and **in that** the grounding unit (5) is provided for also supplying these signals (U_{DE} (t), I_{DE} (t)) to the analysis unit (7), and these signals are evaluated combined and simultaneously with the signals (U_{RC} (t), I_{RC} (t)) from the measurement unit (6) in the analysis unit (7).

5. Apparatus according to one of Claims 1 to 4, **characterized in that** the analysis unit (7) preferably and in particular has means (23, 24) for filtering the signals (U_{RC}(t), I_{RC}(t), U_{DE}(t), I_{DE}(t)) on a frequency-selective basis.

6. Apparatus according to Claim 5, **characterized in that** the means comprise a low-pass filter (24) and a radio-frequency bandpass filter (23), by means of which the signals (U_{RC}(t), I_{RC}(t), U_{DE}(t), I_{DE}(t)) are filtered either simultaneously or in a switched manner, wherein the low-pass filter (24) preferably passes frequencies below 20 kHz, and the radio-frequency bandpass filter (23) preferably passes frequencies in the range from 20 kHz to 40 MHz, and in particular preferably from 1 MHz to 40 MHz.

7. Apparatus according to one of the preceding claims, **characterized in that** means are arranged which additionally supply further signals (which are not based on the measurement of the shaft voltage and/or shaft current) about fault states to the analysis unit (7), and these are monitored and/or analyzed with respect to fault states combined and simultaneously with the shaft voltage (U_{RC}(t), U_{DE}(t)) and/or the shaft current (I_{RC}(t), I_{DE}(t)).

8. Apparatus according to one of the preceding claims, **characterized in that** the analysis unit (7) is provided for the purpose of carrying out the evaluation as a sampling process, preferably using an analog/digital converter, wherein, in particular, a sampling rate is preferably used which corresponds to the mains frequency or to an integer multiple of the mains frequency divided by the number of pole pairs of the generator.

9. The apparatus according to one of the preceding claims, **characterized in that** in the analysis unit (7) provision is made, in order to analyze the shaft voltage (U_{RC}(t), U_{DE}(t)) and/or the shaft current (I_{RC}(t), I_{DE}(t)) for the appropriate shaft voltage signal and/or shaft current signal (U_{RC}(t), I_{RC}(t), U_{DE}(t), I_{DE}(t)) to be investigated with respect to frequency modulations and/or amplitude modulations and/or frequency lines contained in it.

10. Apparatus according to Claim 9, **characterized in that** the analysis unit (7) is designed to evaluate transient processes in the spectrum.

11. Apparatus according to one of Claims 8, 9 or 10, **characterized in that** the analysis unit (7) is designed such that, if necessary after demodulation or down-mixing of the shaft voltage signal and/or shaft current signal (U_{RC}(t), I_{RC}(t), U_{DE}(t), I_{DE}(t)) with a carrier frequency, in particular with the mains frequency (vₘₐᵢₙₛ) or its integer harmonics divided by the number of pole pairs of the generator, these are Fourier transformed in sections, and the resulting spectrum is analyzed for line broadening and/or sidebands and/or for frequency lines in baseband.

12. Apparatus according to one of Claims 9 to 11, **characterized in that** the analysis unit (7) is designed such that the shaft voltage signal and/or shaft current signal is sampled at a sampling rate of 1-200 kHz, in particular for low-frequency components in the region of 5 kHz, and is sampled in the region of 200 kHz for the radio-frequency components, and the signal is then Fourier-transformed in each case in sections in the range from 0.5 k to 1 000 k data points, in particular in the region of 64 k data points, in order to determine fine structures.

13. Apparatus according to Claim 4, **characterized in that** the grounding unit (5) at the first end of the generator (4) towards one end has a high resistance (12) to a contact apparatus (10) to the shaft (2) and has towards the second end a low resistance (13) to the grounding point (8) wherein a fuse (14) is arranged parallel with the high resistance (12), and wherein a measurement resistance (18) is arranged preferably and in particular between the grounding point (8) and the low resistance (13) and wherein the shaft voltage (U_{DE}(t)) is tapped off between the high resistance (12) and the contact apparatus (10) and the grounding point (8), and the shaft current (I_{DE}(t)) is tapped off across the measurement resistance (18).

14. Apparatus according to one of the preceding claims, **characterized in that** the measurement unit (6) has towards one end a fuse (15) to a contact apparatus (11) to the shaft (2) and has towards the other end one or more capacitances (17) which are arranged in parallel and, in parallel with them, a resistance (16) to the grounding point (9), wherein a measurement resistance (18) is arranged between the grounding point (9) and the capacitance (17) as well as between the grounding point (9) and the resistance (16), and wherein the shaft voltage (U_{RC}(t)) is tapped off between the fuse (15) and the grounding point (9), and the shaft current (I_{RC}(t)) is tapped off across the measurement resistance (18).

15. Method for monitoring of electrical machines by means of measurement of shaft voltage (U_{RC}(t)) and/or shaft current (I_{RC}(t)) during operation, wherein the electrical machine has at least one generator (4) with a shaft (2) and drive means (1) for driving this shaft (2), wherein the shaft (2) is grounded at the first end of the generator (4), and wherein a measurement unit (6) for measurement of shaft voltage (U_{RC}(t)) and/or shaft current (I_{RC}(t)) as a function of time is provided on the shaft (2) at the second end of the generator (4), the shaft voltage signal (U_{RC}(t)) and/or shaft current signal (I_{RC}(t)) are supplied to an analysis unit (7), **characterized in that** a combined and simultaneous analysis for at least two potential fault states, which can be determined by means of measurement of shaft voltage signal (U_{RC}(t)) and/or the shaft current signal (I_{RC}(t)), in the electrical machine takes place in the analysis unit (7) with the shaft voltage signal (U_{RC}(t)) and/or shaft current signal (I_{RC}(t)), **in that** the analysis unit (7) evaluates the shaft voltage signal (U_{RC}(t)) and/or shaft current signal (I_{RC}(t)) both in the low-frequency and in the radio-frequency signal ranges, the low-frequency range being used, simultaneously and in a combined form, to determine turns shorts and/or dangerous oscillations of the shaft, and the radio-frequency range being used to determine spark activity, and the evaluation of the signals taking place by means of Fourier transformation.

16. Method according to Claim 15, **characterized in that** the fault states are at least two different fault states selected from the following group:
turns shorts in the rotor winding; functional weakness of the shaft grounding; insulation weakness in the shaft (2); insulation weakness in the rotor winding; brush sparking; partial discharges in the stator and/or in the rotor and/or in the excitor apparatus; dangerous oscillations of the shaft (2); sparks in the excitation apparatus and/or the rotor winding; rotationally synchronous shattering marks and/or witness marks,
and **in that** the method is carried out in particular and preferably using an apparatus according to one of Claims 1 to 14.

## Revendications

1. Dispositif pour surveiller des machines électriques par mesure de la tension d'arbre (U_{RC}(t)) et/ou du courant d'arbre (I_{RC}(t)) en fonctionnement, la machine électrique comprenant au moins un générateur (4) muni d'un arbre (2) ainsi que des moyens d'entraînement (1) pour entraîner cet arbre (2), l'arbre (2) étant mis à la terre du premier côté du générateur (4), une unité de mesure (6) destinée à mesurer la tension d'arbre (U_{RC}(t)) et/ou le courant d'arbre (I_{RC}(t)) en fonction du temps étant prévue sur l'arbre (2) du deuxième côté du générateur (4) et le signal de tension d'arbre (U_{RC}(t)) et/ou le signal de courant d'arbre (I_{RC}(t)) étant acheminés à une unité d'analyse (7), **caractérisé en ce qu'**une analyse combinée et simultanée en vue de déterminer la présence ou non d'au moins deux situations de défaut éventuelles de la machine électrique pouvant être déterminées en mesurant le signal de tension d'arbre (U_{RC}(t)) et/ou le signal de courant d'arbre (I_{RC}(t)) est effectuée dans l'unité d'analyse (7) avec le signal de tension d'arbre (U_{RC}(t)) et/ou le signal de courant d'arbre (I_{RC}(t)), que l'unité d'analyse (7) est prévue pour interpréter le signal de tension d'arbre (U_{RC}(t)) et/ou le signal de courant d'arbre (I_{RC}(t)) aussi bien dans la plage des signaux à basse fréquence que dans celle des signaux à haute fréquence, l'unité d'analyse (7) étant prévue pour utiliser simultanément ou de manière combinée la plage des basses fréquences pour déterminer les courts-circuits d'enroulement et/ou les oscillations dangereuses de l'arbre et la plage des hautes fréquences pour déterminer l'activité radioélectrique et l'interprétation des signaux s'effectuant au moyen d'une transformation de Fourier.

2. Dispositif selon la revendication 1, **caractérisé en ce que** les situations de défaut sont au moins deux situations de défaut différentes choisies parmi le groupe suivant :
courts-circuits dans l'enroulement du rotor ; affaiblissement fonctionnel de la mise à la terre de l'arbre ; faiblesse de l'isolation de l'arbre (2) ; faiblesse de l'isolation de l'enroulement du rotor ; étincelles aux balais ; décharges partielles dans le stator et ou dans le rotor et/ou dans le dispositif excitateur ; oscillations dangereuses de l'arbre (2) ; étincelles dans le dispositif excitateur et/ou l'enroulement du rotor ; traces de broutage et/ou stries synchrones à la rotation.

3. Dispositif selon l'une des revendications précédentes, **caractérisé en ce qu'**au moins l'une des situations de défaut est une activité radioélectrique à haute fréquence comme des étincelles dans le dispositif excitateur et/ou l'enroulement du rotor ou des oscillations dangereuses de l'arbre (2) comme des oscillations de flexion transversales, des mouvements pendulaires ou des oscillations de torsion.

4. Dispositif selon l'une des revendications précédentes, **caractérisé en ce qu'**une unité de mise à la terre (5) est prévue du premier côté du générateur (4) pour relier l'arbre (2) à la terre, laquelle permet de son côté la mesure de la tension d'arbre (U_{DE}(t)) et/ou du courant d'arbre (I_{DE}(t)) en fonction du temps et que l'unité de mise à la terre (5) est prévue pour acheminer également ces signaux (U_{DE}(t), I_{DE}(t)) à l'unité d'analyse (7) et interpréter ceux-ci dans l'unité d'analyse (7) de manière combinée et simultanément avec les signaux (U_{RC}(t), I_{RC}(t)) en provenance de l'unité de mesure (6).

5. Dispositif selon l'une des revendications 1 à 4, **caractérisé en ce qu'**il est notamment préférable que l'unité d'analyse (7) dispose de moyens (23, 24) avec lesquels les signaux (U_{RC}(t), I_{RC}(t), U_{DE}(t), I_{DE}(t)) sont filtrés avec sélection de fréquence.

6. Dispositif selon la revendication 5, **caractérisé en ce que** les moyens sont un filtre passe-bas (24) et un filtre passe-bande à haute fréquence (23) par le biais desquels les signaux (U_{RC}(t), I_{RC}(t), U_{DE}(t), I_{DE}(t)) sont filtrés soit simultanément, soit de manière commutée, le filtre passe-bas (24) laissant de préférence passer les fréquences au-dessous de 20 kHz et le filtre passe-bande à haute fréquence (23) laissant passer les fréquences dans la plage de 20 kHz à 40 MHz, notamment de préférence de 1 MHz à 40 MHz.

7. Dispositif selon l'une des revendications précédentes, **caractérisé en ce qu'**il est mis en place des moyens qui acheminent en plus à l'unité d'analyse (7) des signaux supplémentaires sur des situations de défaut, non basés sur la mesure de la tension d'arbre et/ou du courant d'arbre et ceux-ci sont surveillés ou analysés pour y déceler d'éventuelles situations de défaut en combinaison ou simultanément avec la tension d'arbre (U_{RC}(t), U_{DE}(t)) et/ou le courant d'arbre (I_{RC}(t), I_{DE}(t)).

8. Dispositif selon l'une des revendications précédentes, **caractérisé en ce que** l'unité d'analyse (7) est prévue pour effectuer l'interprétation sous la forme d'un échantillonnage, de préférence en utilisant un convertisseur analogique/numérique, la fréquence d'échantillonnage employée étant notamment de préférence une fréquence qui correspond à la fréquence du réseau ou un multiple entier de la fréquence du réseau divisé par le nombre de paires de pôles du générateur.

9. Dispositif selon l'une des revendications précédentes, **caractérisé en ce que**, dans l'unité d'analyse (7), il est prévu, en vue d'analyser la tension d'arbre (U_{RC}(t), U_{DE}(t)) et/ou le courant d'arbre (I_{RC}(t), I_{DE}(t)), de déterminer le signal de tension d'arbre ou de courant d'arbre (U_{RC}(t), I_{RC}(t), U_{DE}(t), I_{DE}(t)) correspondant en se référant aux modulations de fréquence et/ou aux modulations d'amplitude et/ou aux lignes de fréquence qu'il contient.

10. Dispositif selon la revendication 9, **caractérisé en ce que** l'unité d'analyse (7) est conçue pour interpréter les phénomènes transitoires dans le spectre.

11. Dispositif selon l'une des revendications 8, 9 ou 10, **caractérisé en ce que** l'unité d'analyse (7) est conçue, éventuellement après démodulation ou mélange du signal de tension d'arbre ou du signal de courant d'arbre (U_{RC}(t), I_{RC}(t), U_{DE}(t), I_{DE}(t)) avec une fréquence porteuse, notamment avec la fréquence du réseau (v Réseau) ou ses harmoniques entières divisées par le nombre de paires de pôles du générateur, pour y appliquer une transformation de Fourier par section et pour analyser le spectre résultant pour y déceler d'éventuels élargissements des lignes et/ou bandes latérales et/ou lignes de fréquence dans la bande de base.

12. Dispositif selon l'une des revendications 9 à 11, **caractérisé en ce que** l'unité d'analyse (7) est conçue pour échantillonner le signal de tension d'arbre ou le signal de courant d'arbre avec une fréquence d'échantillonnage de 1-200 kHz, notamment pour les composantes à basse fréquence dans la bande des 5 kHz, et pour les composantes à haute fréquence dans la bande des 200 kHz et ensuite, en vue de déterminer les structures fines, soumettre des portions respectives du signal dans la bande de 0,5k à 1000k points de données à une transformation de Fourier, notamment dans la bande de 64k points de données.

13. Dispositif selon la revendication 4, **caractérisé en ce que** l'unité de mise à la terre (5) dispose du premier côté du générateur (4) d'un côté d'une résistance à forte valeur (12) vers un dispositif de contact (10) sur l'arbre (2) et du deuxième côté d'une résistance à faible valeur (13) vers le point de mise à la terre (8), un fusible (14) étant disposé en parallèle avec la résistance à forte valeur (12) et une résistance de mesure (18) étant disposée de manière particulièrement préférée entre le point de mise à la terre (8) et la résistance à faible valeur (13), la tension d'arbre (U_{DE}(t)) étant prélevée entre la résistance à forte valeur (12) et le dispositif de contact (10) et le point de mise à la terre (8) et le courant d'arbre (I_{DE}(t)) par le biais de la résistance de mesure (18).

14. Dispositif selon l'une des revendications précédentes, **caractérisé en ce que** l'unité de mesure (6) dispose d'un côté d'un fusible (15) vers un dispositif de contact (11) sur l'arbre (2) et de l'autre côté d'un ou plusieurs condensateurs (17) disposés en parallèle, ainsi que, parallèle à ceux-ci, d'une résistance (16) vers la point de mise à la terre (9), une résistance de mesure (18) étant disposée entre le point de mise à la terre (9) et le condensateur (17) et entre le point de mise à la terre (9) et la résistance (16) et la tension d'arbre (U_{RC}(t)) étant prélevée entre le fusible (15) et le point de mise à la terre (9) et le courant d'arbre (I_{RC}(t)) par le biais de la résistance de mesure (18).

15. Procédé pour surveiller des machines électriques par mesure de la tension d'arbre (U_{RC}(t)) et/ou du courant d'arbre (I_{RC}(t)) en fonctionnement, la machine électrique comprenant au moins un générateur (4) muni d'un arbre (2) ainsi que des moyens d'entraînement (1) pour entraîner cet arbre (2), l'arbre (2) étant mis à la terre du premier côté du générateur (4) et une unité de mesure (6) destinée à mesurer la tension d'arbre (U_{RC}(t)) et/ou le courant d'arbre (I_{RC}(t)) en fonction du temps étant prévue sur l'arbre (2) du deuxième côté du générateur (4), le signal de tension d'arbre (U_{RC}(t)) et/ou le signal de courant d'arbre (I_{RC}(t)) étant acheminés à une unité d'analyse (7), **caractérisé en ce qu'**une analyse combinée et simultanée en vue de déterminer la présence ou non d'au moins deux situations de défaut éventuelles de la machine électrique pouvant être déterminées en mesurant le signal de tension d'arbre (U_{RC}(t)) et/ou le signal de courant d'arbre (I_{RC}(t)) est effectuée dans l'unité d'analyse (7) avec le signal de tension d'arbre (U_{RC}(t)) et/ou le signal de courant d'arbre (I_{RC}(t)), que l'unité d'analyse (7) interprète le signal de tension d'arbre (U_{RC}(t)) et/ou le signal de courant d'arbre (I_{RC}(t)) aussi bien dans la plage des signaux à basse fréquence que dans celle des signaux à haute fréquence, la plage des basses fréquences étant utilisée simultanément ou de manière combinée pour déterminer les courts-circuits d'enroulement et/ou les oscillations dangereuses de l'arbre et la plage des hautes fréquences pour déterminer l'activité radioélectrique et l'interprétation des signaux s'effectuant au moyen d'une transformation de Fourier.

16. Procédé selon la revendication 15, **caractérisé en ce que** les situations de défaut sont au moins deux situations de défaut différentes choisies parmi le groupe suivant :
courts-circuits dans l'enroulement du rotor ; affaiblissement fonctionnel de la mise à la terre de l'arbre ; faiblesse de l'isolation de l'arbre (2) ; faiblesse de l'isolation de l'enroulement du rotor ; étincelles aux balais ; décharges partielles dans le stator et/ou dans le rotor et/ou dans le dispositif excitateur ; oscillations dangereuses de l'arbre (2) ; étincelles dans le dispositif excitateur et/ou l'enroulement du rotor ; traces de broutage et/ou stries synchrones à la rotation, et que le procédé est de manière particulièrement préférée mis en oeuvre en utilisant un dispositif selon l'une des revendications 1 à 14.
